(19) Europäisches Patentamt
European Patent Office
Office européen des brevets

(11) **EP 3 559 688 B1**

(12) **FASCICULE DE BREVET EUROPEEN**

(45) Date de publication et mention
de la délivrance du brevet:
**23.08.2023 Bulletin 2023/34**

(21) Numéro de dépôt: **17826207.7**

(22) Date de dépôt: **18.12.2017**

(51) Classification Internationale des Brevets (IPC):
**G01R 31/36** (2020.01)  **G01R 31/367** (2019.01)
**G01R 31/382** (2019.01)  **G01R 31/392** (2019.01)

(52) Classification Coopérative des Brevets (CPC):
**G01R 31/392; G01R 31/367; G01R 31/382**

(86) Numéro de dépôt international:
**PCT/EP2017/083400**

(87) Numéro de publication internationale:
**WO 2018/114860 (28.06.2018 Gazette 2018/26)**

(54) **CARACTÉRISATION PERFECTIONNÉE D'UN DISPOSITIF ÉLECTROCHIMIQUE EN OPÉRATION POUR UN PRONOSTIC DE FONCTIONNEMENT FUTUR DU DISPOSITIF**

VERBESSERTE CHARAKTERISIERUNG EINER ELEKTROCHEMISCHEN VORRICHTUNG IM BETRIEB ZUR VORHERSAGE DES KÜNFTIGEN BETRIEBS DER VORRICHTUNG

IMPROVED CHARACTERISATION OF AN ELECTROCHEMICAL DEVICE IN OPERATION FOR A PROGNOSIS OF THE FUTURE OPERATION OF THE DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2016 FR 1663122**

(43) Date de publication de la demande:
**30.10.2019 Bulletin 2019/44**

(73) Titulaire: **Electricité de France**
**75008 Paris (FR)**

(72) Inventeur: **KÄNDLER, Christoph**
**76709 Kronau (DE)**

(74) Mandataire: **Plasseraud IP**
**66, rue de la Chaussée d'Antin**
**75440 Paris Cedex 09 (FR)**

(56) Documents cités:
**US-A1- 2011 196 633    US-A1- 2014 214 348**
**US-A1- 2014 244 193    US-A1- 2015 046 108**
**US-A1- 2016 041 231    US-A1- 2016 202 324**

EP 3 559 688 B1

**Description**

L'invention concerne les dispositifs électrochimiques et plus particulièrement une méthode de pronostics d'un fonctionnement futur de tels dispositifs.

Communément, des dispositifs tels que les sources d'énergie ou les convertisseurs électrochimiques (batteries, piles à combustible, super capacités, batteries redox, ou autres), ou encore les procédés électrochimiques employant des électrolyseurs avec ou sans séparateur et/ou membrane (pour l'électrodéposition, l'électroérosion, l'électro-flottation, ou autres), sont soumis à des dynamiques propres:

- à chaque application dans laquelle ils interviennent, et
- aux constituants-mêmes de tels dispositifs.

Ainsi, de nombreuses variables physiques doivent être prises en compte, par exemple la température, l'humidité absolue ou relative, la pression, les débits, la puissance générée ou consommée, et/ou autres.

Habituellement, ces variables sont couplées de manière non linéaire, de sorte que le changement de l'une d'elles influence les autres.

Les modèles utilisés actuellement requièrent des puissances de calcul et/ou des quantités de mémoire élevées. Leur précision peut alors s'avérer faible. Ces modèles peuvent nécessiter aussi un grand nombre de capteurs, difficilement intégrables dans un dispositif opérationnel.

De plus, du fait des couplages et des interactions entre les variables et/ou un organe de contrôle de fonctionnement et/ou l'environnement, les comportements dynamiques sont souvent très difficiles à prendre en compte. En outre, les phénomènes évoluent rapidement et typiquement il ne peut être observé un régime permanent, assez stable dans le temps pour anticiper un pronostic a priori. On connaît de US 2016/041231 A1 un procédé et un appareil pour estimer la vie d'une batterie considérant l'utilisation de la batterie. On connaît de US 2014/214348 A1, US 2014/244193 A1, US 2011/196633 A1, US 2016/202324 A1 et US 2015/046108 A1, procédés et appareils de détermination de l'état de charge d'une batterie considérant aussi l'utilisation de la batterie.

La présente invention vient améliorer la situation.

Elle propose à cet effet un procédé, selon la revendication 1, de caractérisation d'un dispositif électrochimique en opération pour un pronostic de fonctionnement futur du dispositif. Les revendications dépendantes 2-11 définissent des implémentations supplémentaires.

La présente invention vise aussi un module, selon la revendication 12, de traitement de données issues d'un dispositif électrochimique en opération, pour un pronostic de fonctionnement futur du dispositif.

La présente invention vise aussi un programme informatique comportant des instructions pour la mise en oeuvre du procédé présenté ci-avant, lorsque ce programme est exécuté par le module de l'invention.

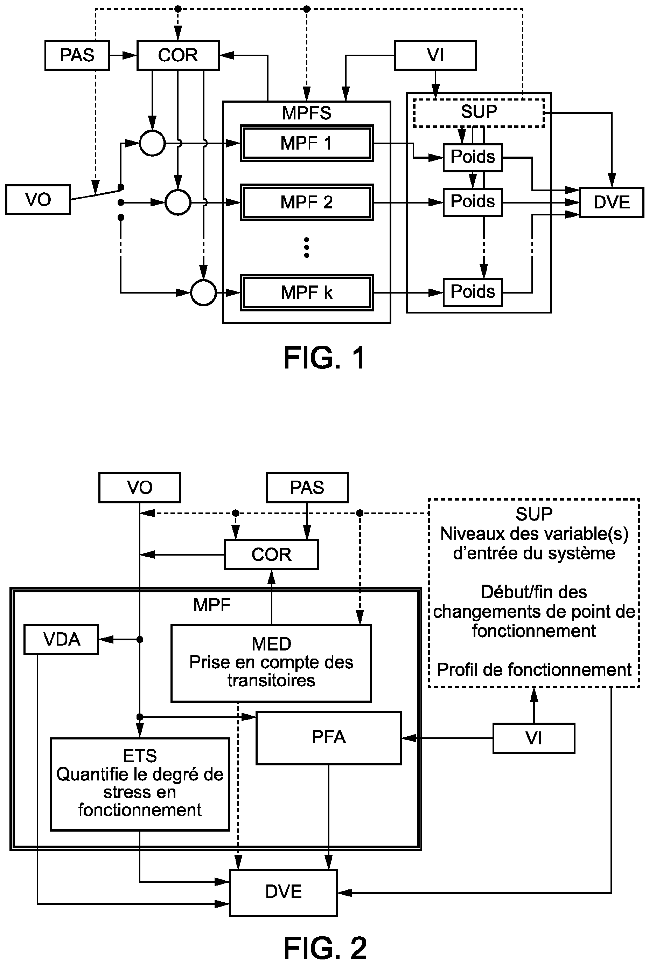

A titre d'exemple, la figure 1 présente un ordinogramme possible de l'algorithme général d'un tel programme. La figure 2 illustre l'ordinogramme possible d'un détail de l'algorithme qui concerne des prises en compte supplémentaires possibles pour l'estimation de la durée de vie restante du dispositif.

Ainsi, l'invention permet de réaliser un modèle de pronostics ou d'estimation de la durée de vie restante pour chaque point de fonctionnement d'un dispositif électrochimique, mettant en oeuvre une séparation entre les dynamiques et les régimes de fonctionnement stationnaires, comme détaillé ci-après.

Cette séparation se traduit par différents modèles simplifiés de fonctionnement en régime permanent. Les comportements dynamiques complexes, inutiles et/ou parasites pour le pronostic ou l'estimation de la durée de vie restante de ces dispositifs, peuvent être analysés et corrigés.

La paramétrisation de ces modèles multiples peut être automatisée car l'utilisation d'un seul ou de quelques seulement de ces modèles est suffisante, réduisant ainsi la puissance de calcul nécessaire, pour l'estimation d'un pronostic ou de la durée de vie restante d'un dispositif électrochimique.

Selon une approche de l'invention, plusieurs modèles sont utilisés, plutôt qu'un seul modèle qui serait plus gros et complexe, afin de décomposer les effets non linéaires en sous-parties plus facilement manipulables.

D'autres avantages et caractéristiques de l'invention apparaîtront à la lecture de la description d'exemples de réalisation détaillée ci-après, et à l'examen des dessins annexes, sur lesquels :

- la figure 1 présente un exemple d'approche algorithmique générale d'un procédé au sens de l'invention,
- la figure 2 présente plus en détails le principe et la structure d'un modèle utilisé pour un point de fonctionnement donné MPF, ainsi que ses sous-ensembles d'interaction avec un module de supervision SUP, en illustrant alors les chemins des signaux traités et la manière dont le module superviseur peut basculer entre les différents modèles en cas de changement de point de fonctionnement,
- les figures 3a et 3b présentent les variations temporelles respectivement en tension (V) et en courant (I), en changeant alors les points d'opération successifs OPC du fonctionnement d'une pile à combustible dans l'exemple représenté ; en particulier, la figure 3a compare la tension prédite par pronostic PROG à la tension réellement mesurée MES,
- les figures 4a et 4b présentent les variations en tension (V) et en courant (I), au fur et à mesure de charges CHAR et de décharges DISC d'une batterie rechargeable dans l'exemple représenté, respectivement pour de premières heures d'utilisation et après plus de 3300 heures d'utilisation,

- la figure 5 illustre un exemple de module de traitement, physique (hardware) pour la mise en oeuvre de l'invention.

En référence à la figure 1, on prévoit une décomposition d'un système de pronostic comme suit :

- des modèles multiples MPF1, MPF2, ..., MPFk, pour chaque point de fonctionnement considéré,

- un module de supervision SUP,

- un module de correction COR d'une ou plusieurs variables de sortie du système VO, comme décrit plus loin, et

- un module d'estimation, finalement, de la durée de vie restante DVE du dispositif électrochimique.

Il est possible de gérer un système non linéaire en séparant son fonctionnement en différents régimes, comme illustré sur la figure 1 (différents modèles de point de fonctionnement).

Les différents niveaux de la (ou des) variable(s) d'entrée peuvent être considérés comme des points de fonctionnement. On peut considérer qu'ils sont fixés à des niveaux constants, mais différents pour chaque point de fonctionnement. La(ou les) variable(s) d'entrée considérée(s) sont utilisée(s) comme critère(s) principal(aux) du choix du modèle à utiliser.

Ainsi, chaque point de fonctionnement est associé à un modèle propre, donné pour estimer une vitesse de vieillissement du dispositif, mais il s'est révélé toutefois que tous ces modèles ont une structure comparable, d'où l'intérêt de l'approche de l'invention.

Le module de supervision peut fixer des poids (entre 0 et 1) à appliquer aux différents modèles, à des fins d'optimisation. L'entrée ou les entrées de chaque modèle est/sont fixée(s) par le module de supervision. Par ailleurs, chaque modèle utilise au moins une variable issue d'une sortie du dispositif, cette variable étant choisie de sorte qu'elle est associée à son point de fonctionnement. Chaque modèle contient au moins un traitement de cette variable (par exemple le calcul de l'écart-type au sein d'une fenêtre glissante de la variable considérée), ainsi que la vitesse courante de dégradation (comme présenté plus loin). Il contient également un module de traitement des transitoires liées à un changement du point de fonctionnement, et un module estimant un présent degré de contrainte ainsi que son historique.

La (ou les) variable de sortie doit être régulée et ne dépendre que d'au moins une variable d'entrée, en prenant la précaution toutefois que cette dépendance soit sans lien avec une boucle de régulation que peut mettre en oeuvre un module de supervision pour contrôler le fonctionnement du dispositif électrochimique. Ces éléments servent à déterminer la vitesse de dégradation de ce dernier afin d'estimer sa durée de vie restante. Ainsi, le module de supervision peut informer le module d'estimation de durée de vie, d'un profil du fonctionnement en cours du dispositif, et plus particulièrement du point de fonctionnement actuel du dispositif. Une autre tâche du modèle de supervision est de sélectionner le modèle de point de fonctionnement à utiliser et d'informer du type de transitoires en cours, afin de corriger au moins une des variables de sortie du système illustré sur la figure 1 (via des modèles d'événements discrets et via la correction de paramètres significatifs, comme décrit en détails ci-après). Ces paramètres représentent typiquement l'influence, souvent supérieure à celle du vieillissement, de l'environnement sur les variables de sortie du système.

On procède dans une forme de réalisation à une correction des variables de sorties du système afin d'éliminer les effets parasites d'un signal de sortie donné, sur le vieillissement de certaines variables, et des transitoires précitées, pour se focaliser plutôt sur les différentes conditions opératoires associées aux différentes variables d'entrée.

La durée de transmission entre deux points de fonctionnement peut être très courte par rapport à celle d'un point de fonctionnement, mais cette transition peut avoir un effet beaucoup plus grand sur les variables de sortie, que le vieillissement lui-même. Afin de résoudre ce problème, des « modèles d'événements discrets » sont utilisés pour corriger les variables de sortie. Ces modèles ne sont utilisés qu'au cours d'un événement transitoire. La fin d'une transition d'une ou plusieurs des variables d'entrée est utilisée pour déclencher l'exécution du modèle. Ensuite, le module de supervision peut corriger la valeur de la variable de sortie en entrée du modèle de point de fonctionnement. On peut ainsi éliminer les effets des transitoires pour quantifier l'effet du vieillissement. Lorsqu'un nouveau régime permanent est atteint, le modèle d'événement discret est désactivé jusqu'au prochain changement de point de fonctionnement.

Du fait du caractère non linéaire des dispositifs électrochimiques, chaque modèle de point de fonctionnement utilise un jeu de paramètres, propre, en entrée du modèle d'événement discret. En effet, la réponse à un créneau ou une rampe diffère selon les niveaux actuel et précédent d'une ou des variables d'entrée du système. Pour affecter un modèle approprié d'événement discret à la correction des variables de sortie, le module de supervision informe le modèle de point de fonctionnement du type de transition réalisée et des niveaux de variable(s) d'entrée à partir desquels cette transition a commencé.

Par ailleurs, différents paramètres (par exemple la température) peuvent avoir des effets plus importants sur les variables de sortie, que le vieillissement lui-même. Ces paramètres sont donc corrigés avant d'être utilisés en entrée du modèle de point de fonctionnement.

La figure 2 présente à titre illustratif des informations que chaque modèle de point de fonctionnement envoie au module de prédiction de durée de vie restante, afin d'estimer la ou les valeur(s) de variable(s) de sortie en fonction du profil de la ou des variable(s) d'entrée.

Plus particulièrement, à partir de variables d'entrée du système VI, un modèle de point de fonctionnement MPF peut déterminer un point de fonctionnement actuel PFA, en vue d'estimer la durée de vie DVE restant au dispositif électrochimique. Néanmoins, cette estimation est affinée par des informations que peut délivrer le module de supervision SUP, capable de définir notamment :

- des niveaux des variables d'entrée VI,
- un début et une fin de changement(s) de point de fonctionnement,
- un profil de fonctionnement,
- et/ou autres.

Ces informations peuvent être transmises à un modèle d'événement discret MED pour la prise en compte des transitoires (intégré dans le modèle de point de fonctionnement MPF dans l'exemple illustré sur la figure 2). Ainsi, ce modèle d'événement discret MED peut corriger l'interprétation des variables de sortie du système VO (ainsi que d'autres paramètres significatifs PAS éventuels, comme la température par exemple), afin de définir plus précisément, notamment :

- le point de fonctionnement actuel PFA, et
- la vitesse de dégradation actuelle VDA.

A partir de ces estimations du point de fonctionnement actuel PFA et de la vitesse de dégradation VDA, et éventuellement d'un écart-type ETS quantifiant un degré de stress du dispositif en fonctionnement comme on le verra plus loin, il est possible d'affiner l'estimation de la durée de vie restante DVE, en particulier dans le cas d'une transition de fonctionnement.

Par exemple, dans le cas d'une pile à combustible, la fonction suivante peut être utilisée :

$$\text{SOV}_{est} = m_{age} \times \text{SIV}(t_{seq}) + \text{SOV}_{act} \, ,$$

où:

- $\text{SOV}_{est}$ et $\text{SOV}_{act}$ correspondent aux valeurs respectivement estimée et mesurée d'une variable de sortie,
- $\text{SIV}(t_{seq})$ correspond au profil attendu d'une variable d'entrée considérée (ainsi que sa durée, $t_{seq}$ représentant le temps), et
- $m_{age}$ correspond à la vitesse de dégradation.

Cette vitesse de dégradation $m_{age}$ peut être déterminée par apprentissage en effectuant plusieurs estimations successives (par exemple de pronostics) basées sur une succession de points d'opération respectifs dont les données ont pu être couramment récupérées et stockées en mémoire, et ce en implémentant répétitivement le procédé au sens de l'invention avec une pluralité de points d'opération successifs.

Tant que la ou les variables de sortie du système sont en régime permanent, la vitesse de dégradation est supposée constante jusqu'à la fin de vie du dispositif électrochimique. Si les conditions opératoires changent, en revanche, l'estimation de durée de vie prend en compte ce changement pour estimer à nouveau la vitesse de dégradation et la durée de vie du dispositif dans ses nouvelles conditions de fonctionnement.

Le vieillissement est lié aux conditions de fonctionnement du dispositif électrochimique et à ses différentes variables. S'il fonctionne dans des conditions normales ou à des points de fonctionnement relativement non stressants, le dispositif vieillit moins vite et cette observation est prise en compte pour l'estimation de la durée de vie restante. De plus, la vitesse de dégradation peut être hétérogène au sein du dispositif. Ces aspects sont pris en compte par l'approche par modèles multiples : chaque modèle de fonctionnement correspond à un niveau différent des variables d'entrée du système et prend en compte sa vitesse de dégradation.

Bien entendu, le ou les signaux qui sont issus du dispositif révèlent ses conditions actuelles. Les évolutions des variables de sortie d'un dispositif fonctionnant dans des conditions stressantes peuvent par exemple être plus bruitées. Aussi, ces variables présentent un écart-type ETS glissant plus élevé et la valeur de cet écart-type peut représenter un critère de stabilité du dispositif.

Préférentiellement, une phase d'apprentissage est prévue afin d'expérimenter au moins une fois chaque point de fonctionnement et chaque changement entre deux points de fonctionnement, de manière à assigner des vitesses de dégradation correspondantes et déterminer les corrections à apporter.

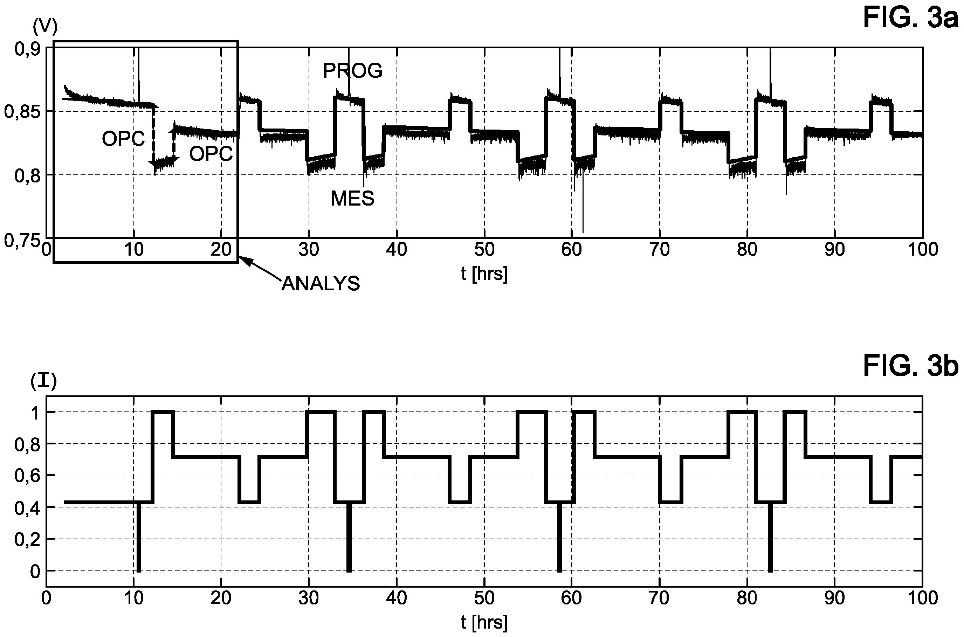

On se réfère maintenant à la figure 3a. Elle représente dans l'exemple décrit le comportement d'une pile à combustible, en tension, au fur et à mesure de son utilisation. Il apparaît que sur une consigne d'utilisation de la pile, qu'indique directement le courant (I), il est possible d'établir la définition d'un ou plusieurs points d'opérations successifs OPC. Ici la tension (V) est l'une des variables de sortie et la valeur de consigne donnée par le courant (I) peut être l'une des variables d'entrée du modèle. Comme la réaction d'un tel dispositif électrochimique à une consigne donnée est propre à la nature et aux constituants-mêmes du dispositif, il est avantageusement prévu une fenêtre d'observation ANALYS de ce comportement dans les premières heures de cycle, dans l'exemple représenté. Ainsi, l'analyse du comportement de la tension (V) en ces différents points d'opérations (fenêtre ANALYS) permet de déterminer un pronostic PROG, dans des conditions d'opération similaire, en tenant compte toutefois d'une décroissance de la tension (V) inhérente aux cycles d'utilisation successifs au cours du temps t (ici, compté en heures). Bien entendu, ce pronostic peut être estimé en outre en fonction de points de fonctionnement précédemment identifiés et déterminés, éventuellement dans des fenêtres d'analyse antérieures. Néanmoins, dans l'exemple représenté, le modèle de décroissance en tension PROG suit bien les variations de la tension réellement mesurée MES au cours du temps. On relèvera effectivement que le modèle PROG suit bien les trois niveaux de variation en tension, imposée par les trois valeurs de courant (I) (hormis la valeur de zéro, bien entendu). On peut relever aussi, dans l'exemple illustré, que l'écart-type dans la variation de la tension (V) augmente dans le temps. Cette observation est utile en outre pour estimer la décroissance de la tension en fonction du temps.

On peut observer éventuellement une légère différence, au bout d'un nombre d'heures élevé, entre la valeur de pronostic et la valeur réellement mesurée (cette dernière pouvant être légèrement inférieure à celle mesurée). Cette observation est alors inhérente au dispositif électrochimique, lui-même, et au vieillissement particulier de ses composants, dans son environnement d'utilisation. Dans ce cas, il peut être utile de corriger la valeur de pronostic pour le comportement futur du dispositif, pour rendre cette estimation conforme à l'observation présente.

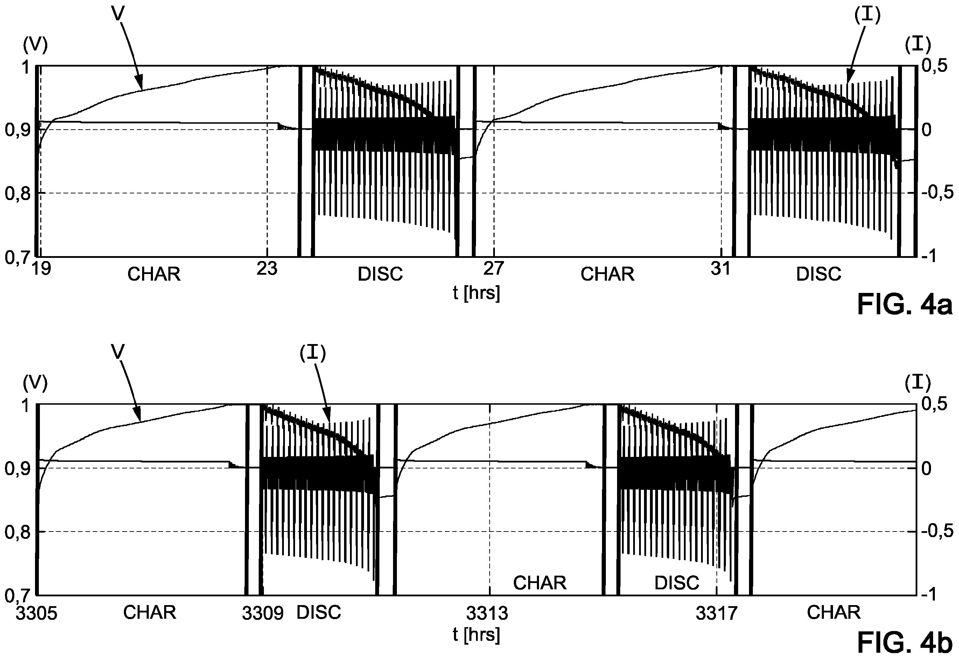

On se réfère maintenant aux figures 4a et 4b pour observer une application de l'invention, pour un autre type de dispositif électrochimique, ici une batterie rechargeable. On observe par exemple que les durées de charge complète CHAR et de décharge complète DISC (chaque événement de charge et de décharge définissant un point de fonctionnement en tant que tel) augmente au fur et à mesure des cycles de charge/décharge. Ainsi, déjà, la durée d'une décharge ou d'une charge complètes est un indice de pronostic de la durée de vie restante d'un tel dispositif électrochimique. Par ailleurs, on peut observer en outre le comportement du dispositif pendant des cycles successifs d'utilisation (pendant les périodes de décharge DISC). Dans ce cas, une observation fine du comportement tension (V) relativement au courant (I) peut donner encore, comme décrit précédemment, une estimation de la durée de vie restante de la batterie.

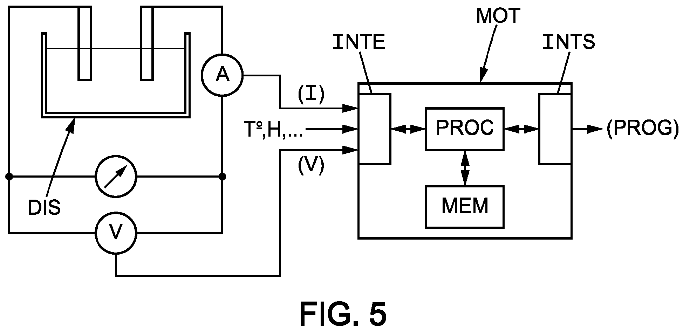

En référence à la figure 5, un module de traitement MOT pour la mise en oeuvre de l'invention peut comporter une interface d'entrée INTE, afin de recevoir plusieurs signaux issus du dispositif électrochimique surveillé DIS, dont notamment :

- une consigne de commande du dispositif DIS, tel que le courant (I) qu'il doit fournir par exemple, en tant que variable d'entrée du système précité,
- une variable de fonctionnement du dispositif DIS, telle que la tension à ses bornes (V), en tant que variable sortie du système, et
- éventuellement un ou plusieurs signaux issus de capteurs disposés dans le dispositif électrochimique DIS, tels que par exemple une mesure de température T°, une mesure de degré d'humidité H, et/ou autres.

Le module de traitement MOT comporte en outre un processeur PROC pour traiter ces données, ainsi qu'une mémoire MEM pour stocker des données temporaires de calcul, ainsi que des données durables telles que des instructions d'un programme informatique pour la mise en oeuvre du procédé au sens de l'invention, et, bien entendu, les données des modèles associés à chaque point de fonctionnement.

Le module de traitement MOT comporte en outre une interface de sortie INTS pour délivrer un signal de pronostic PROG, et éventuellement de durée de vie de restante, estimée, du dispositif électrochimique DIS. Bien entendu, ce signal PROG peut alimenter une interface homme-machine (non représentée, telle qu'un écran ou autre) pour informer un utilisateur d'une durée de vie restante, le cas échéant.

## Revendications

1. Procédé de caractérisation d'un dispositif électrochimique d'un type donné, en opération, pour un pronostic de fonctionnement futur du dispositif selon ladite opération, le procédé comportant :

    - Une étape préalable de stockage en mémoire, pour un type de dispositif correspondant audit type donné, d'une pluralité de modèles de variation dans le temps d'au moins un paramètre de fonctionnement du dispositif, en fonction de points d'opération respectifs du dispositif, et
    - Des étapes courantes ultérieures mises en oeuvre par un processeur accédant à ladite mémoire et comportant au moins une connexion au dispositif pour:

        - Obtenir une information relative à un point d'opération courant du dispositif,
        - Récupérer dans la mémoire au moins un modèle de variation correspondant au point d'opération courant du dispositif,
        - Recevoir du dispositif au moins une mesure d'une valeur courante du paramètre de fonctionnement,
        - Comparer ladite mesure au modèle de variation récupéré de la mémoire, pour situer temporellement le fonctionnement du dispositif, et, de là,
        - Estimer un pronostic de fonctionnement du dispositif,

    ledit point d'opération courant du dispositif étant défini en fonction :

- d'au moins une variable d'entrée, correspondant à un paramètre de fonctionnement imposé au dispositif électrochimique, et
- d'au moins une variable de sortie, correspondant à un paramètre que délivre le dispositif électrochimique relativement à son fonctionnement.

2. Procédé selon la revendication 1, dans lequel le paramètre de fonctionnement est une tension à des bornes du dispositif.

3. Procédé selon l'une des revendications précédentes, dans lequel les modèles de variation stockés dans la mémoire comportent des modèles de décroissance de la tension à des bornes du dispositif en fonction du temps, selon différents points d'opération donnés.

4. Procédé selon l'une des revendications précédentes, dans lequel le pronostic de fonctionnement est estimé en fonction d'une pluralité de modèles stockés en mémoire (MPF1, MPF2, ..., MPFk), et pondérés par des poids respectifs définis en fonction du point d'opération courant.

5. Procédé selon l'une des revendications précédentes, dans lequel le dispositif électrochimique étant apte à fournir de l'énergie électrique, une variable d'entrée est un courant de fonctionnement imposé au dispositif, tandis qu'une variable de sortie est une tension à des bornes du dispositif.

6. Procédé selon l'une des revendications précédentes, le procédé comportant en outre une correction appliquée à ladite au moins une variable de sortie, en fonction d'une détection d'au moins une transitoire liée à un changement de point de fonctionnement du dispositif.

7. Procédé selon l'une des revendications précédentes, le procédé comportant en outre une correction appliquée à ladite au moins une variable de sortie, en fonction d'au moins un paramètre significatif du dispositif, mesuré par un capteur, parmi au moins une température et un degré d'humidité du dispositif.

8. Procédé selon l'une des revendications précédentes, dans lequel on estime une durée de vie restante du dispositif, au moins en fonction d'un point de fonctionnement actuel (PFA).

9. Procédé selon la revendication 8, dans lequel la durée de vie restante du dispositif est estimée en outre à partir d'une vitesse de dégradation actuelle du dispositif (VDA), déterminée par apprentissage de comportement du dispositif.

10. Procédé selon l'une des revendications précédentes, dans lequel on ' évalue en outre un écart-type dans le temps de ladite mesure de valeur courante du paramètre de fonctionnement, ledit écart-type quantifiant un degré de stress de fonctionnement du dispositif, pris en compte pour une estimation d'une durée de vie restante du dispositif.

11. Procédé selon l'une des revendications précédentes, le procédé étant mis en oeuvre répétitivement pour une pluralité de points d'opération successifs, en ce que des informations respectivement relatives auxdits points successifs d'opération du dispositif sont obtenues et stockées successivement en mémoire, et en ce que l'estimation du pronostic de fonctionnement du dispositif est opérée sur la base du point d'opération courant et desdits points successifs d'opération.

12. Module de traitement de données issues d'un dispositif électrochimique d'un type donné, en opération, pour un pronostic de fonctionnement futur du dispositif selon ladite opération, le module comportant :

    - une mémoire de stockage (MEM) au moins d'une pluralité de modèles de variation dans le temps d'au moins un paramètre de fonctionnement du dispositif, en fonction de points d'opération respectifs du dispositif, et pour un type de dispositif correspondant audit type donné,
    - une interface d'entrée (INTE) pour recevoir du dispositif au moins une mesure d'une valeur courante du paramètre de fonctionnement,
    - un processeur (PROC) connecté à la mémoire et à l'interface d'entrée pour exécuter les étapes du procédé selon l'une des revendications précédentes, et
    - une interface de sortie (INTS) pour délivrer un pronostic de fonctionnement du dispositif selon un point d'opération courant,

    ledit point d'opération courant du dispositif étant défini en fonction :

    - d'au moins une variable d'entrée, correspondant à un paramètre de fonctionnement imposé au dispositif électrochimique, et
    - d'au moins une variable de sortie, correspondant à un paramètre que délivre le dispositif électrochimique relativement à son fonctionnement.

13. Programme informatique comportant des instructions pour la mise en oeuvre du procédé selon l'une des revendications 1 à 11, lorsque ce programme est exécuté par le module selon la revendication 12.

**Patentansprüche**

1. Verfahren zur Charakterisierung einer elektrochemischen Vorrichtung eines gegebenen Typs im Betrieb für eine Funktionsprognose der Vorrichtung gemäß dem Betrieb, wobei das Verfahren Folgendes umfasst:

   - einen vorherigen Schritt der Speicherung einer Vielzahl von Modellen der zeitlichen Veränderung wenigstens eines Betriebsparameters der Vorrichtung in Abhängigkeit von jeweiligen Betriebspunkten der Vorrichtung für einen Typ der Vorrichtung, der dem gegebenen Typ entspricht, in einem Speicher, und
   - spätere laufende Schritte, die von einem Prozessor ausgeführt werden, der auf den Speicher zugreift und wenigstens eine Verbindung zur Vorrichtung aufweist, zum:

     - Abrufen von Informationen zu einem aktuellen Betriebspunkt der Vorrichtung,
     - Abrufen aus dem Speicher von wenigstens einem Variationsmodell, das dem aktuellen Betriebspunkt der Vorrichtung entspricht,
     - Empfangen wenigstens einer Messung eines aktuellen Werts des Betriebsparameters von der Vorrichtung,
     - Vergleichen der Messung mit dem aus dem Speicher abgerufenen Variationsmodell, um den Betrieb der Vorrichtung zeitlich einzuordnen, und, von dort aus,
     - Abschätzen einer Funktionsprognose der Vorrichtung,

   wobei der aktuelle Betriebspunkt der Vorrichtung definiert ist als Funktion von:

     - wenigstens einer Eingangsvariablen, die einem der elektrochemischen Vorrichtung auferlegten Betriebsparameter entspricht, und
     - wenigstens einer Ausgangsvariablen, die einem Parameter entspricht, den die elektrochemische Vorrichtung in Bezug auf ihren Betrieb liefert.

2. Verfahren nach Anspruch 1, wobei der Betriebsparameter eine Spannung an den Anschlüssen der Vorrichtung ist.

3. Verfahren nach einem der vorhergehenden Ansprüche, wobei die im Speicher gespeicherten Variationsmodelle Modelle des Abfalls der Spannung an den Anschlüssen der Vorrichtung als Funktion der Zeit bei verschiedenen gegebenen Betriebspunkten umfassen.

4. Verfahren nach einem der vorhergehenden Ansprüche, wobei die Funktionsprognose auf der Grundlage einer Vielzahl von im Speicher gespeicherten Modellen (MPF1, MPF2, ..., MPFk) geschätzt wird, die mit jeweiligen Gewichten gewichtet werden, die in Abhängigkeit vom aktuellen Betriebspunkt festgelegt werden.

5. Verfahren nach einem der vorhergehenden Ansprüche, wobei die elektrochemische Vorrichtung elektrische Energie liefern kann, eine Eingangsvariable ein der Vorrichtung auferlegter Betriebsstrom ist, während eine Ausgangsvariable eine Spannung an den Anschlüssen der Vorrichtung ist.

6. Verfahren nach einem der vorhergehenden Ansprüche, wobei das Verfahren ferner eine Korrektur der wenigstens einen Ausgangsvariablen in Abhängigkeit von der Erfassung wenigstens einer Transiente umfasst, die mit einer Änderung des Betriebspunkts der Vorrichtung verbunden ist.

7. Verfahren nach einem der vorhergehenden Ansprüche, wobei das Verfahren ferner eine Korrektur der wenigstens einen Ausgangsvariablen in Abhängigkeit von wenigstens einem signifikanten Parameter der Vorrichtung umfasst, der von einem Sensor gemessen wird, der wenigstens eine Temperatur und einen Feuchtigkeitsgrad der Vorrichtung umfasst.

8. Verfahren nach einem der vorhergehenden Ansprüche, wobei eine Restlebensdauer der Vorrichtung wenigstens in Abhängigkeit von einem aktuellen Betriebspunkt (AWP) geschätzt wird.

9. Verfahren nach Anspruch 8, wobei die verbleibende Lebensdauer der Vorrichtung zusätzlich anhand einer aktuellen Abbaugeschwindigkeit der Vorrichtung (VDA) geschätzt wird, die durch Lernen des Verhaltens der Vorrichtung ermittelt wird.

10. Verfahren nach einem der vorhergehenden Ansprüche, wobei ferner eine zeitliche Standardabweichung der Messung des aktuellen Wertes des Betriebsparameters ausgewertet wird, wobei die Standardabweichung einen Grad an Betriebsstress der Vorrichtung quantifiziert, der bei einer Schätzung der Restlebensdauer der Vorrichtung berücksichtigt wird.

11. Verfahren nach einem der vorhergehenden Ansprüche, wobei das Verfahren für eine Vielzahl von aufeinanderfolgenden Betriebspunkten wiederholt wird, wobei Informationen, die sich jeweils auf die aufeinanderfolgenden Betriebspunkte der Vorrichtung beziehen, nacheinander erhalten und im Speicher gespeichert werden, und wobei die Schätzung der Betriebsprognose der Vorrichtung auf der Grundlage des aktuellen Betriebspunkts und der aufeinanderfolgenden Betriebspunkte durchgeführt wird.

**12.** Modul zur Verarbeitung von Daten, die von einer elektrochemischen Vorrichtung eines gegebenen Typs im Betrieb stammen, für eine Funktionsprognose der Vorrichtung gemäß diesem Betrieb, wobei das Modul umfasst:

- einen Speicher (MEM) für die Speicherung wenigstens einer Vielzahl von Modellen für die zeitliche Veränderung wenigstens eines Betriebsparameters der Vorrichtung in Abhängigkeit von den jeweiligen Betriebspunkten der Vorrichtung und für einen Typ der Vorrichtung, der dem genannten gegebenen Typ entspricht,
- eine Eingabeschnittstelle (INTE), um von der Vorrichtung wenigstens eine Messung eines aktuellen Werts des Betriebsparameters zu empfangen,
- einen Prozessor (PROC), der mit dem Speicher und der Eingabeschnittstelle verbunden ist, um die Schritte des Verfahrens nach einem der vorhergehenden Ansprüche auszuführen, und
- eine Ausgabeschnittstelle (INTS) zum Ausgeben einer Funktionsprognose der Vorrichtung gemäß einem aktuellen Betriebspunkt,

wobei der aktuelle Betriebspunkt der Vorrichtung definiert wird, abhängig von:

- wenigstens einer Eingangsvariablen, die einem der elektrochemischen Vorrichtung auferlegten Betriebsparameter entspricht, und
- wenigstens einer Ausgangsvariablen, die einem Parameter entspricht, den die elektrochemische Vorrichtung in Bezug auf ihren Betrieb liefert.

**13.** Computerprogramm mit Anweisungen zur Durchführung des Verfahrens nach einem der Ansprüche 1 bis 11, wenn dieses Programm von dem Modul nach Anspruch 12 ausgeführt wird.

**Claims**

**1.** Method for characterizing an electrochemical device of a given type, in operation, for a prognosis of future operation of the device according to said operation, the method comprising:

- A preliminary step of storage in memory, for a type of device corresponding to that given type, of a plurality of models of variation over time of at least one operating parameter of the device, depending on the respective operating points of the device, and
- Subsequent common steps implemented by a processor accessing said memory and having at least one connection the device for:

- Obtain information relating to a common operating point of the device,
- Retrieve in the memory at least one variation pattern corresponding to the current operating point of the device,
- Receive from the device at least one measurement of a current value of the operating parameter,
- Compare said measurement to the model of variation retrieved from memory, to locate temporally the operation of the device, and, from there,
- Estimate a prognosis of operation of the device,

said current operating point of the device being defined according to:

- at least one input variable, corresponding to an operating parameter imposed on the electrochemical device, and
- at least one output variable, corresponding to a parameter delivered by the electrochemical device in relation to its operation.

**2.** The method of claim 1, wherein the operating parameter is a voltage across the device.

**3.** A method according to one of the preceding claims, wherein the variation models stored in memory comprise models of decrease of the voltage at terminals of the device as a function of time, according to different given operating points.

**4.** A method according to one of the preceding claims, wherein the operating prognosis is estimated according to a plurality of models stored in memory (MPF1, MPF2, ..., MPFk), and weighted by respective weights defined according to the current operating point.

**5.** A method according to one of the preceding claims, wherein, the electrochemical device being able to provide electrical energy, an input variable is an operating current imposed on the device, while an output variable is a voltage across the device.

**6.** A method according to one of the preceding claims, the method further comprising a correction applied to said at least one output variable, based on a detection of at least one transient related to a change in operating point of the device.

**7.** A method according to one of the preceding claims, the method further comprising a correction applied to said at least one output variable, as a function of at least one significant parameter of the device, measured by a sensor, among at least one temperature and one degree of humidity of the device.

**8.** A method according to one of the preceding claims, wherein a remaining life of the device is estimated, at least based on a current operating point (PFA).

**9.** The method of claim 8, wherein the remaining life of the device is further estimated from a current degradation rate of the device (VDA), determined by learning the behavior of the device.

**10.** A method according to one of the preceding claims, wherein further evaluates a standard deviation in time of said measurement of current value of the operating parameter, said standard deviation quantifying a degree of operating stress of the device, taken into account for an estimate of a remaining life of the device.

**11.** A method according to one of the preceding claims, the method being implemented repeatedly for a plurality of successive operating points, in that information respectively relating to said successive operating points of the device are obtained and stored successively in memory, and in that the estimation of the prognosis of operation of the device is made on the basis of the current operating point and said successive operating points.

**12.** Module for processing data from an electrochemical device of a given type, in operation, for a prognosis of future operation of the device according to said operation, the module comprising:

- a storage memory (MEM) at least a plurality of models of variation over time of at least one operating parameter of the device, depending on the respective operating points of the device, and for a type of device corresponding to said given type,
- an input interface (INTE) to receive from the device at least one measurement of a current value of the operating parameter,
- a processor (PROC) connected to the memory and input interface to execute the process steps according to one of the preceding claims, and
- an output interface (INTS) to deliver a prognosis of operation of the device according to a common point of operation,

said current operating point of the device being defined according to:

- at least one input variable, corresponding to an operating parameter imposed on the electrochemical device, and
- at least one output variable, corresponding to a parameter delivered by the electrochemical device in relation to its operation.

**13.** A computer program comprising instructions for implementing the method according to one of claims 1 to 11, when this program is executed by the module according to claim 12.

**FIG. 1**

**FIG. 2**

**FIG. 3a**

PROG

OPC

OPC

MES

ANALYS

(V)

0,9

0,85

0,8

0,75

10  20  30  40  50  60  70  80  90  100

t [hrs]

**FIG. 3b**

(I)

1

0,8

0,6

0,4

0,2

0

10  20  30  40  50  60  70  80  90  100

t [hrs]

FIG. 4a

FIG. 4b

EP 3 559 688 B1

FIG. 5

## RÉFÉRENCES CITÉES DANS LA DESCRIPTION

**Documents brevets cités dans la description**

- US 2016041231 A1
- US 2014214348 A1
- US 2014244193 A1
- US 2011196633 A1
- US 2016202324 A1
- US 2015046108 A1